(19) Europäisches Patentamt
European Patent Office
Office européen des brevets

(11) **EP 2 881 749 B1**

(12) **EUROPEAN PATENT SPECIFICATION**

(45) Date of publication and mention
of the grant of the patent:
**04.01.2017 Bulletin 2017/01**

(21) Application number: **12882158.4**

(22) Date of filing: **31.07.2012**

(51) Int Cl.:
***G01R 31/36*** *(2006.01)*

(86) International application number:
**PCT/JP2012/004871**

(87) International publication number:
**WO 2014/020643 (06.02.2014 Gazette 2014/06)**

(54) **CONTROL METHOD AND CONTROL DEVICE USING SAME**

STEUERUNGSVERFAHREN UND STEUERUNGSVORRICHTUNG DAFÜR

PROCÉDÉ DE CONTRÔLE ET DISPOSITIF DE CONTRÔLE L'UTILISANT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**10.06.2015 Bulletin 2015/24**

(73) Proprietor: **Panasonic Intellectual Property
Management Co., Ltd.**
**Osaka-shi, Osaka 540-6207 (JP)**

(72) Inventors:
• **IKEBE, Hayato**
**Osaka-shi, Osaka 540-6207 (JP)**
• **OUE, Yasuhiro**
**Osaka-shi, Osaka 540-6207 (JP)**
• **OKUDA, Yasuo**
**Osaka-shi, Osaka 540-6207 (JP)**

(74) Representative: **Appelt, Christian W.
Boehmert & Boehmert
Anwaltspartnerschaft mbB
Patentanwälte Rechtsanwälte
Pettenkoferstrasse 20-22
80336 München (DE)**

(56) References cited:
**JP-A- 2008 256 673       JP-A- 2009 190 690
JP-A- 2010 032 480       JP-A- 2012 073 175
US-A1- 2005 001 627      US-A1- 2010 121 587
US-A1- 2010 244 846**

**Description**

[TECHNICAL FIELD]

The present invention relates to a control technology and, more particularly, a method of controlling a rechargeable battery and a controller using the method.

[BACKGROUND ART]

Performance of secondary batteries such as rechargeable batteries is degraded by being used repeatedly. In order to understand the degree of performance degradation, the state of health is acquired. In order to know the battery property easily, the battery capacity and the internal resistance corresponding to the measured charge voltage are recursively calculated based on a function f and on the battery capacity and the internal resistance previously measured. When the calculation is completed, the battery capacity and the internal resistance are recorded, mapping them to the date and time of measurement, the battery temperature, the charge voltage, and the charge time, in addition to the battery capacity and the internal resistance calculated.

Patent document 1: JP2011-75461

US 2010244846 (A1) describes a method for determining the state of health (SOH) of a battery in which cell impedance is determined continuously, and including determining one or more confidence coefficients that depend on one or several variables selected from cell current, temperature or state of charge or their derivatives or integrals with respect to time, and continuously determining the state of health of the battery at a given point in time, using the state of health of the battery at a preceding point in time corrected as a function of cell impedance determined at the given point in time and weighted by the confidence coefficient or coefficients.

US 2005/001627 (A1) describes a model of battery reserve life where a function of a SOH indicator is adaptively modified responsive to intermittent capacity tests of a battery, e.g., based on reserve life estimates generated responsive to the capacity tests. The SOH indicator for the battery is monitored to generate SOH indicator values, and estimates of reserve life are generated from the generated SOH indicator values according to the adaptively modified model of reserve life.

US 2010/121587 (A1) describes systems and methods for health management of rechargeable batteries. In one embodiment, a rechargeable battery system includes a rechargeable battery, and a battery health management unit operatively coupled to the rechargeable battery and including a state of health module configured to estimate a battery health by receiving battery-related data and predicting one or more failure modes. The state of health module may further include a prognostic failure mode component configured to combine at least one flight data variable with at least one model-based prognostic.

JP 2008256673 (A) describes a battery control method and system wherein internal resistance values obtained based on measured data are managed for every temperature, with sample data thereof increased for every temperature and with the internal resistance values averaged. Then, the averaged internal resistance values are compared with a reference internal resistance value over the whole temperatures.

JP 2010032480 (A) describes a diagnosis system for cars with a diagnostic system consisting of a car failure diagnosis apparatus implementing analysis of engine-related conditions based on reading of fault cord of the car from a connector and exhaust gas components measured by an exhaust gas measuring instrument, a battery measuring instrument capable of measuring performance data of a battery, and an information operation processing device implementing synthetic diagnostics and management of the car using information from both the car failure diagnosis apparatus and the battery measuring instrument.

JP 2012073175 (A) describes a cell state display device which displays a battery state of a battery pack composed of a plurality of individual cells. A cell state detection means acquires measurement result information showing the measurement result of the cell state for each individual cell. A control means causes a display means to display the cell state of each individual cell based on the acquired measurement result information.

[PROBLEM TO BE SOLVED BY THE INVENTION]

In this background, we have come to realize the following problems. The state of health is generally derived by charging and discharging a battery. For this reason, the reliability of the state of health may be subject to variation, depending on the manner in which the battery is charged and discharged. If the actual state of health is poorer than the state of health acquired, disadvantages may be caused if the user believes the state of health acquired.

The present invention addresses this issue and a purpose thereof is to provide a technology of making known the reliability of the state of health.

[MEANS TO SOLVE THE PROBLEM]

A controller according to an embodiment present invention that addresses the issue includes a first acquisition unit that acquires a state of health of a rechargeable battery that should supply power to a load; a second acquisition unit that acquires a reliability of the state of health acquired by the first acquisition unit; and an output unit that outputs the state of health acquired by the first acquisition unit and the reliability acquired by the second acquisition unit.

Another embodiment of the present invention relates to a control method. The method includes: acquiring a state of health of a rechargeable battery that should supply power to a load; acquiring a reliability of the acquired state of health; and outputting the acquired state of health and the acquired reliability.

Optional combinations of the aforementioned constituting elements, and implementations of the invention in the form of methods, apparatuses, systems, recording mediums, and computer programs may also be practiced as additional modes of the present invention.

[ADVANTAGE OF THE PRESENT INVENTION]

According to the invention, the reliability of the state of health can be made known.

[BRIEF DESCRIPTION OF THE DRAWINGS]

Figs. 1A-1C show the configuration of a power distribution system according to the first exemplary embodiment;
Fig. 2 shows the configuration of the manager of Figs. 1A-1C;
Fig. 3 shows an on-screen image displayed on the display of Fig. 2;
Fig. 4 shows an on-screen image displayed on the display according to the second exemplary embodiment;
Fig. 5 is a flowchart showing the steps of displaying performed by the manager according to the second exemplary embodiment of the present invention;
Fig. 6 is a flowchart showing the steps of updating performed by the manager according to the third exemplary embodiment of the present invention;
Fig. 7 shows an on-screen image displayed on the display according to the fourth exemplary embodiment of the present invention;
Fig. 8 is a flowchart showing the steps of displaying performed by the manager according to the fourth exemplary embodiment of the present invention;
Fig. 9 shows the configuration of the manager according to the fifth exemplary embodiment of the present invention;
Fig. 10 is a flowchart showing the steps of inputting the full charge capacity performed by the manager of Fig. 9;
Fig. 11 shows the data structure of the table stored in the storage according to the sixth exemplary embodiment of the present invention;
Fig. 12 is a flowchart showing the steps of inputting the full charge capacity performed by the manager according to the sixth exemplary embodiment;
Fig. 13 is a flowchart showing the steps of inputting the full charge capacity performed by the manager according to the seventh exemplary embodiment of the present invention; and
Fig. 14 is a flowchart showing the steps of acquiring the full charge capacity performed by the manager according to the eighth exemplary embodiment of the present invention.

[BEST MODE FOR CARRYING OUT THE INVENTION]

(First exemplary embodiment)

A summary will be given before describing the invention in detail. The first exemplary embodiment of the present invention relates to a power distribution system in which a solar cell is connected in parallel with a commercial power system, power is supplied from a commercial power supply, the solar cell, and a rechargeable battery to a load, and the rechargeable battery is charged. When the commercial power supply fails, power from the solar cell or the rechargeable battery is supplied to the load. The rechargeable battery may be configured not to be discharged when the commercial power supply is active. The rechargeable battery in this system is degraded with time. It is therefore desired that the degree of degradation and life of the rechargeable battery be made known in order to prevent a situation in which the rechargeable battery is not available when it should be available. The degree of degradation and life of a rechargeable battery is determined by referring to the state of health (SOH). Normally, SOH is measured when the battery is charged or discharged. However, when discharge control where SOH is hardly measured is in effect, SOH may be different from the current value. The power distribution system according to this exemplary embodiment displays the date and time of updating SOH as well as displaying SOH.

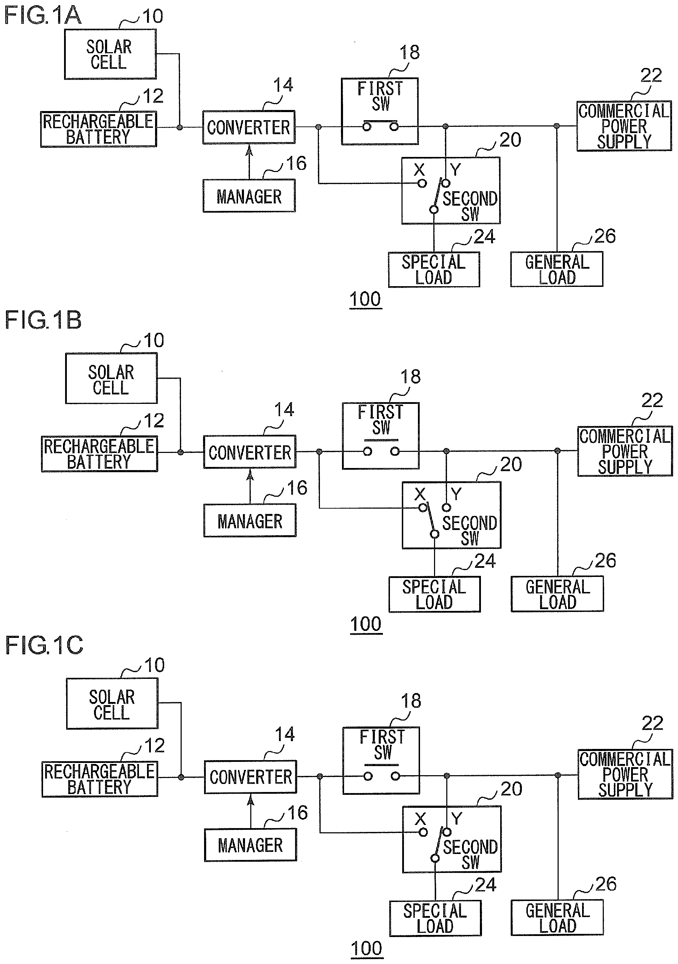

Figs. 1A-1C show the configuration of a power distribution system 100 according to the first exemplary embodiment. Referring to Fig. 1A, the power distribution system 100 includes a solar cell 10, a rechargeable battery 12, a converter 14, a manager 16, a first SW 18, a second SW 20, a special load 24, and a general load 26. The power distribution system 100 is connected to a commercial power supply 22. The commercial power supply 22 is an AC power supply for supplying power from a utility company. Fig. 1A shows the configuration of the power distribution system 100 obtained when the commercial power supply 22 is active (hereinafter, referred to as "during normal operation").

The solar cell 10 is an electric device for directly converting light energy into power using photovoltaic effect. A silicon solar cell, a solar cell formed by a compound semiconductor, a dye-sensitised solar cell (organic solar cell), etc. is used as the solar cell 10. The solar cell 10 outputs the generated power. The rechargeable battery 12 is charged by the power generated based on a renewable energy source, i.e., by the power generated by the solar cell 10 or the power from the commercial power supply 22.

The solar cell 10 is connected to one end of the converter 14. The route between the converter 14 and the solar cell 10 branches in the middle and the rechargeable battery 12 is connected to the branch. In other words, the solar cell 10 and the rechargeable battery 12 are connected in parallel to one end of the converter 14 via a branch node. The commercial power supply 22 is connected to the other end of the converter 14. The manager 16 outputs a direction for controlling the operation of the rechargeable battery 12 to the converter 14. The converter 14 monitors voltage variation on the route between the first SW 18 and the commercial power supply 22 and determines whether the commercial power supply 22 fails or conducts by referring to the detected voltage variation.

The general load 26 is an AC-driven electric device. The general load 26 is connected to a branch from the route between the converter 14 and the commercial power supply 22. A distribution panel (not shown) is connected to the route between the converter 14 and the commercial power supply 22 more toward the commercial power supply 22 than the branch node connected to the commercial power supply 22.

The first SW 18 and the second SW 20 are switches for changing the route in accordance with a direction from the manager 16. On and off switching of the first SW 18 and the second SW 20 is directed by the converter 14. Alternatively, the manager 16 may provide directions. During normal operation, the first SW 18 is turned on and the second SW 20 is connected to the Y terminal. As a result, the Y terminal of the second SW 20 is connected to the special load 24. The special load 24 is an AC-driven electric device similar to the general load 26.

The rechargeable battery 12 is charged during normal operation in the following manner. If the utility company employs a time-of-day system to charge for electricity, the electricity rate is lower at night time than in daytime. By way of example, daytime is defined as 7 to 23 and night time is defined as 23 to 7. Therefore, at night time, the power supplied from the commercial power supply 22 is used to charge the rechargeable battery 12 via the first SW 18 and the converter 14. In this process, the converter 14 converts the AC power fed from the commercial power supply 22 into DC power and outputs the DC power to the rechargeable battery 12.

In daytime, the power generated by the solar cell 10 is output to the converter 14. The converter 14 converts the DC power fed from the solar cell 10 into AC power and outputs the AC power to the first SW 18. As a result, the power from the solar cell 10 is supplied to the special load 24 and the general load 26. Further, if the power generated by the solar cell 10 is larger than the power consumed by the special load 24 and the general load 26, the excess power is charged in the rechargeable battery 12. The rechargeable battery 12 supplies power to a load when the commercial power supply fails. During normal operation, the rechargeable battery 12 does not discharge its power to the special load 24. The rechargeable battery 12 discharges its power to the special load 24 only in the event of power failure. During normal operation, the rechargeable battery 12 may be used to discharge power for peak cut, i.e. to lower the maximum quantity of commercial power used in daytime, when the quantity of electricity used is generally large. A description of peak cut will be omitted.

Fig. 1B shows the configuration of the power distribution system 100 obtained when the commercial power supply 22 fails (hereinafter, referred to as "during power failure"). When the commercial power supply 22 stops supplying power, the converter 14 detects power failure. When power failure is detected, the converter 14 controls the first SW 18 and the second SW 20. To describe it more specifically, the first SW 18 is turned off and the second SW 20 is connected to the X terminal during power failure. As a result, the special load 24 is connected to the converter 14, but the general load 26 is disconnected from the converter 14. Therefore, the power from the solar cell 10 is output to the converter 14 and the power from the converter 14 is supplied to the special load 24. If the power consumed by the special load 24 is smaller than the power from the solar cell 10, the excess power is charged in the rechargeable battery 12. If the power consumed by the special load 24 during power failure is larger than the power from the solar cell 10, the rechargeable battery 12 outputs power. The discharged power is output to the converter 14 and the power from the converter 14 is supplied to the special load 24.

As described, the special load 24 can receive power from the solar cell 10, the rechargeable battery 12, and the commercial power supply 22 during normal operation. During power failure, the special load 24 can receive power from the solar cell 10 and the rechargeable battery 12. Meanwhile, the general load 26 can receive power from the solar cell 10, the rechargeable battery 12, and the commercial power supply 22 during normal operation but cannot receive power during power failure.

Fig. 1C shows the configuration obtained when the commercial power supply 22 recovers from power failure and returned to a state in which power failure does not occur (hereinafter, referred to as "during recovery"). When the supply of power from the commercial power supply 22 is recovered during power failure, the converter 14 detects the recovery. When the recovery is detected, the converter 14 controls the second SW 20. To describe it more specifically, the first SW 18 is maintained to be turned off and the second SW 20 is connected to the Y terminal. As a result, the special load 24 and the general load 26 are disconnected from the converter 14 and are connected to the commercial power supply 22. As a result, the power from the commercial power supply 22 is supplied to the special load 24 and the general load 26. Since the special load 24 and the general load 26 are not connected to the converter 14, the converter 14 does not output AC power. The power generated by the solar cell 10 is supplied to the rechargeable battery 12.

During normal operation shown in Fig. 1A, the converter 14 performs grid connected operation. Meanwhile, during power failure shown in Fig. 1B and during recovery shown in Fig. 1C, the converter 14 performs grid independent operation. Grid connected operation is an operation whereby the converter 14 generates AC power from DC power by using a frequency dependent on the frequency of power of the commercial power supply 22. Meanwhile, grid independent operation is an operation whereby the converter 14 generates AC power from DC power by using a frequency independent on the frequency of the power of the commercial power supply 22.

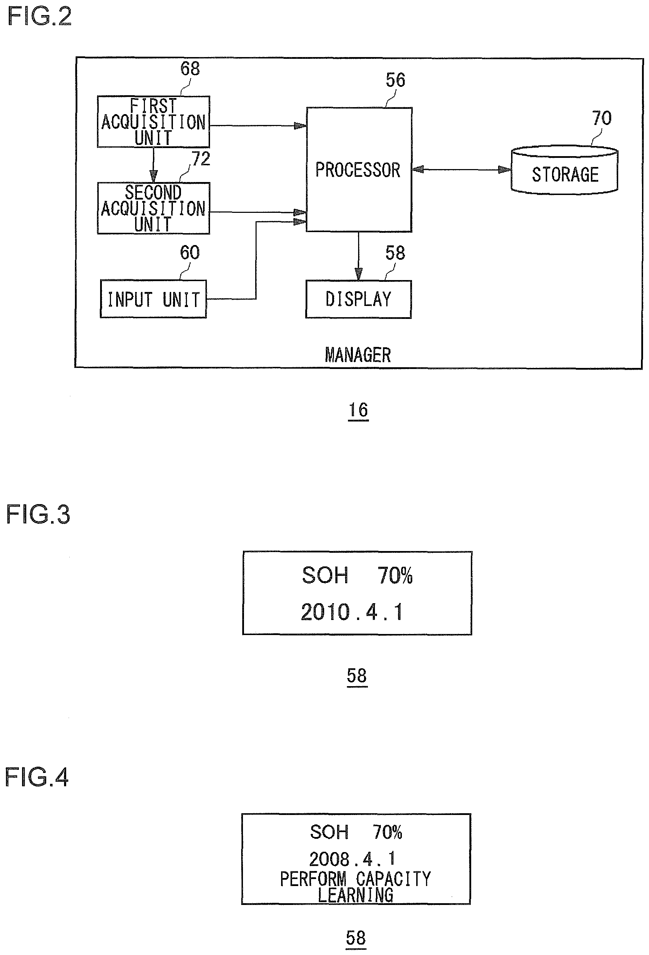

Fig. 2 shows the configuration of the manager 16. The manager 16 includes a processor 56, a display 58, an input unit 60, a first acquisition unit 68, a storage 70, a second acquisition unit 72. As described above, the manager 16 controls the operation of the rechargeable battery 12. The description below concerns a process related to SOH and a description of other processes will be omitted.

The first acquisition unit 68 acquires the SOH of the rechargeable battery 12 if a certain constant quantity of power is charged in or discharged from the rechargeable battery 12. The more the rechargeable battery 12 is degraded, the smaller the SOH. The SOH is derived as follows.

$$SOH = \text{current full charge capacity}/\text{initial full charge capacity} \quad (1)$$

The current full charge capacity is derived as follows.

$$\text{Current full charge capacity} = \text{coefficient } K \times \text{current value } I \text{ integrated over a predefined period of time} \quad (2)$$

A description will now be given of the calculation method of expression (2). The coefficient K is predefined by, for example, measurement. More specifically, the coefficient K is determined based on a difference in the state of charge (hereinafter, SOC) defined with respect to predefined voltage variation. For example, given a predefined variation from V1 to V2 (V1>V2), V1 denoting a voltage corresponding to SOC75% and V2 corresponding to SOC50%, the coefficient K is determined such that K=100/(75-50)=4.

Given that the integrated current value that flows when the rechargeable battery is discharged such that the voltage changes from V1 to V2 (V1>V2) in a predefined period of time is 10 Ah, the current full charge capacity=4×10Ah. As the degradation of the battery proceeds, the current is reduced so that the integrated current value is also reduced. Thus, for derivation of SOH, the integrated current value I is required. For derivation of the integrated current value I, charging and discharging of the rechargeable battery 12 is required. Therefore, the first acquisition unit 68 acquires the SOH of the rechargeable battery 12 while the rechargeable battery 12 is charged or discharged. The first acquisition unit 68 outputs the acquired SOH to the processor 56.

The second acquisition unit 72 acquires the reliability of the state of health acquired by the first acquisition unit 68. The reliability of the state of health as explained in this exemplary embodiment means a time of updating the state of health acquired by the first acquisition unit 68. The time of updating is denoted by year, month, and day. The time of updating may include hour, minute, and second. The second acquisition unit 72 outputs the acquired time of updating to the processor 56. The processor 56 receives the SOH from the first acquisition unit 68 and receives the timing of updating from the second acquisition unit 72. The processor 56 combines the SOH and the time of updating and stores the combination in the storage 70. The storage 70 stores the SOH and the time of updating as combined.

The input unit 60 is provided with a button and receives an instruction from the user via the button. One example is an instruction to control the rechargeable battery 12. It will be assumed here that an instruction to display the SOH is input. The input unit 60 outputs the input instruction to the processor 56. When an instruction to display the SOH is received, the processor 56 extracts a combination of the SOH and the time of updating from the storage 70 and outputs the combination to the display 58. The display 58 displays the combination of the SOH and the time of updating received from the processor 56 on a monitor. Fig. 3 shows an on-screen image displayed on the display 58. The SOH is shown toward the top and the time of updating is shown below.

The features are implemented in hardware such as a CPU of a computer, a memory, or other LSI's, and in software such as a program loaded into a memory, etc. The figure depicts functional blocks implemented by the cooperation of these elements. Therefore, it will be obvious to those skilled in the art that the functional blocks may be implemented in a variety of manners by hardware only or by a combination of hardware and software.

According to this exemplary embodiment of present invention, the time of updating is displayed along with the SOH. Therefore, the user can know when the state of health was acquired. If the time of updating is old, the user can know that the reliability of SOH is low. If the reliability is low, the SOH is not relied upon so that troubles are avoided. Since what is only required is to add the time of updating, the throughput is prevented from increasing.

(Second exemplary embodiment)

Like the first exemplary embodiment, the second exemplary embodiment relates to a manager adapted to display the SOH and also display the timing of updating. The manager according to the second exemplary embodiment additionally displays a message alerting the user. The power distribution system 100 and the manager 16 according to the second exemplary embodiment are of the same type as those of Figs. 1A-1C and Fig. 2. The following description concerns the difference.

When an instruction to display the SOH is received from the input unit 60, the processor 56 of Fig. 2 acquires a combination from the storage 70. The processor 56 extracts the time of updating included in the combination. If the time of updating precedes a predefined period of time before present, the processor 56 outputs a message to the display 58 prompting the user to perform capacity learning of the rechargeable battery 12. For example, the predefined period of time is determined to be three years preceding the current date and time. In this process, the processor 56 also outputs the SOH and the time of updating to the display 58.

If the time of updating indicates a date and time earlier than the predefined period of time in the past, the display 58 displays a message on the monitor prompting the user to perform capacity learning of the rechargeable battery 12. Fig. 4 shows an on-screen image displayed on the display 58 according to the second exemplary embodiment. The SOH is shown toward the top, the time of updating is shown in the middle, and a message "please perform capacity learning" is shown at the bottom. The user seeing the message updates the SOH by performing capacity learning. Capacity learning is a process whereby the rechargeable battery 12 is discharged and then charged afresh.

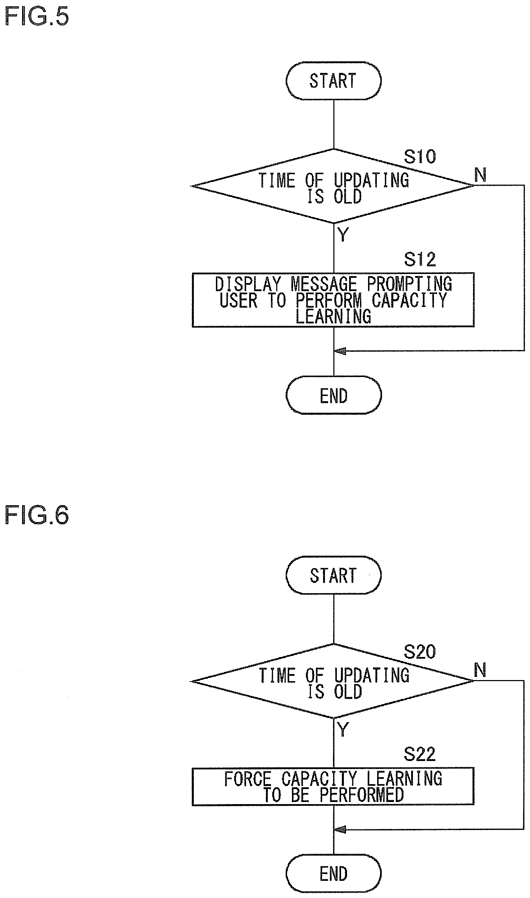

A description will now be given of the operation of the power distribution system 100 having the structure described above. Fig. 5 is a flowchart showing the steps of displaying performed by the manager 16 according to the second exemplary embodiment of the present invention. If the time of updating received by the processor 56 is old (Y in S10), the display 58 displays a message prompting the user to perform capacity learning (S12). If the time of updating received by the processor 56 is not old (N in S10), step 12 is skipped.

According to this exemplary embodiment, a message prompting the user to perform capacity learning of the rechargeable battery is displayed so that the SOH can be updated. Further, by displaying a message prompting the user to perform capacity learning of the rechargeable battery, the user initiated process is directly designated. Updating of the SOH allows the user to use a highly reliable SOH.

(Third exemplary embodiment)

Like the preceding embodiments, the third exemplary embodiment relates to a manager adapted to display the SOH and also display the timing of updating. The manager according to the second exemplary embodiment forces capacity learning to be performed. The power distribution system 100 and the manager 16 according to the third exemplary embodiment are of the same type as those of Figs. 1A-1C and Fig. 2. The following description essentially concerns the difference.

When an instruction to display the SOH is received from the input unit 60, the processor 56 of Fig. 2 acquires a combination from the storage 70. The processor 56 extracts the time of updating included in the combination. If the time of updating precedes a predefined period of time before present, i.e., if the time of updating indicates a date and time earlier than the predefined period of time in the past, the processor 56 forces capacity learning of the rechargeable battery 12 to be performed. A publicly known technology may be used for capacity learning so that a description thereof will be omitted.

As a result of the process described above, the processor 56 acquires the new SOH via the first acquisition unit 68 and acquires the new time of updating via the second acquisition unit 72. As described above, the processor 56 combines the SOH and the time of updating and causes the storage 70 to store the combination. The storage 70 combines the SOH with the time of updating and stores the combination. The display 58 displays the combination of the SOH and the time of updating received from the processor 56 on a monitor.

Fig. 6 is a flowchart showing the steps of updating performed by the manager 16 according to the third exemplary embodiment of the present invention. If the time of updating received by the processor 56 is old (Y in S20), the processor 56 forces capacity learning to be performed (S22). If the time of updating received by the processor 56 is not old (N in S20), step 22 is skipped.

According to this exemplary embodiment, capacity learning is performed so that the SOH can be updated. Because capacity learning is forced to be performed, the user initiated processes is simplified.

(Fourth exemplary embodiment)

Like the preceding embodiments, the fourth exemplary embodiment relates to a manager adapted to display the SOH and also display the timing of updating. The manager according to the fourth exemplary embodiment additionally communicates the fact that the timing of updating is old.

The power distribution system 100 and the manager 16 according to the fourth exemplary embodiment are of the same type as those of Figs. 1A-1C and Fig. 2. The following description essentially concerns the difference.

When an instruction to display the SOH is received from the input unit 60, the processor 56 of Fig. 2 acquires a combination from the storage 70. The processor 56 extracts the time of updating included in the combination. If the time of updating precedes a predefined period of time before present, the processor 56 outputs a message to the display 58 prompting the user to perform capacity learning of the rechargeable battery 12. For example, the predefined period of time is determined to be three years preceding the current date and time. In this process, the processor 56 also outputs the SOH and the time of updating to the display 58.

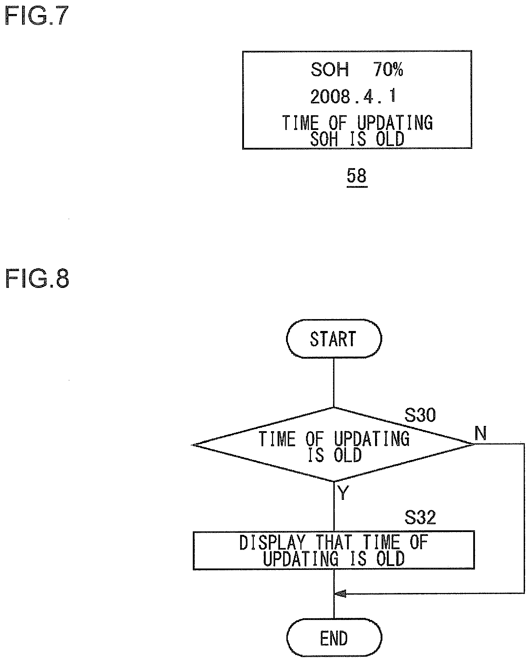

If the time of updating indicates a date and time earlier than the predefined period of time in the past, the display 58 indicates on the monitor that the time of updating is old. Fig. 7 shows an on-screen image displayed on the display 58 according to the fourth exemplary embodiment of the present invention. Fig. 4 shows an on-screen image displayed on the display 58 according to the second exemplary embodiment. The SOH is shown toward the top, the time of updating is shown in the middle, and a message "the time of updating the SOH is old" is shown at the bottom. The user seeing the message recognizes that the reliability of the SOH is low. The fact that the time of updating the SOH is old may not be presented as a message but by a background color of the monitor different from normal. Still alternatively, the time of updating may be highlighted or shown blinking.

Fig. 8 is a flowchart showing the steps of displaying performed by the manager 16 according to the fourth exemplary embodiment of the present invention. If the time of updating received by the processor 56 is old (Y in S30), the display 58 displays a message indicating that the time of updating is old (S32). If the time of updating received by the processor 56 is not old (N in S30), step 32 is skipped.

According to this exemplary embodiment, a message indicating that the time of updating is old is displayed so that the user is alerted accordingly. By using a background color, highlighting, and blinking, etc., the throughput can be prevented from increasing.

(Fifth exemplary embodiment)

Like the preceding embodiments, the fifth exemplary embodiment relates to a power distribution system. The knowledge behind the fifth exemplary embodiment is as follows. A battery pack accommodating a rechargeable battery is used in mobile devices such as notebook personal computers, cell phones, etc. When the battery in the battery pack runs out, the mobile device may go inoperative during use or the data is lost. In order to avoid such troubles, battery packs provided with the function of displaying the remaining battery capacity are used. The remaining battery capacity is calculated and displayed by detecting the charging and discharging current of the battery and subjecting the current value to integration or subtraction. When the remaining capacity is detected by integrating the charging and discharging current, the precision of detection is degraded by repeating charging and discharging or by the memory effect. The reset button is therefore turned on when the refresh charging and discharging is completed so that the detection value of the remaining capacity is defined as the fully charged state. Further, the information indicating the number of times of charging and discharging is corrected as appropriate when the rechargeable battery is replaced.

An example of the information related to a trouble of a battery is the state of health. In this background, we have become aware of the following fact. The initial full charge capacity is used to calculate the state of health. Normally, a default value is used for the initial full charge capacity. However, the default value cannot properly be used as the initial full charge capacity when the device calculating the state of health is replaced instead of the battery. Even when the battery is replaced, the initial full charge capacity may be different from the default value due to battery-to-battery differences. In this background, a purpose of the fifth exemplary embodiment is to provide a technology capable of flexibly setting the initial full charge capacity when the usage environment of the battery is changed.

To describe it more specifically, the manager stores the initial full storage capacity that should be used to calculate the SOH. There are cases where the initial full charge capacity needs to be changed. One is a case where the manager is replaced, and the other is a case where the rechargeable battery is replaced. In the related art, a default value has been used as the initial full charge capacity if the usage environment of the rechargeable battery is changed. To address situations where the default value is not favorable as described above, the manager according to this exemplary embodiment performs the following process. The manager receives an input of the initial full charge capacity when the manager is connected to a new power distribution system or when the rechargeable battery is replaced and sets the input as the initial full charge capacity. The power distribution system 100 according to the fifth exemplary embodiment is of the same type as that of Figs. 1A-1C. The following description essentially concerns the difference.

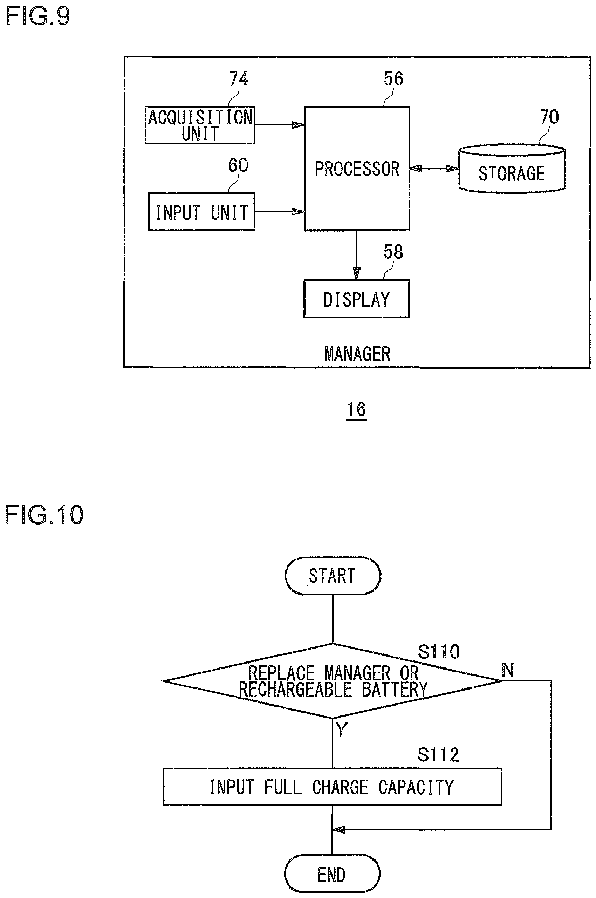

Fig. 9 shows the configuration of the manager 16. The manager 16 includes a processor 56, a display 58, an input unit 60, an acquisition unit 74, and a storage 70. As described above, the manager 16 controls the operation of the rechargeable battery 12. The following description concerns the process related to SOH, and, in particular, the setting of the initial full charge capacity. A description of the other features will be omitted.

The storage 70 stores the initial full charge capacity of the rechargeable battery 12. The rechargeable battery 12 supplies power to the special load 24 described above and subject to control by the manager 16. The acquisition unit 74 performs the same process as the first acquisition unit 68 of Fig. 2 so that a description thereof will be omitted.

When the SOH is received from the acquisition unit 74, the processor 56 causes the storage 70 to store the SOH. When an instruction is received from the input unit 60, the processor 56 performs a process designated by the instruction, using the SOH. One of the process performed using the SOH is to display the SOH on the display 58. In this process, the processor 56 receives an instruction to display the SOH from the input unit 60. This is equivalent to the processor 56 performing the process by using the full charge capacity stored in the storage 70. By allowing the processor 56 to perform the process, the display 58 displays the SOH.

The input unit 60 is provided with a button, etc. and receives an instruction from the user via the button. One example is an instruction to control the rechargeable battery 12. It will be assumed here that an instruction to display the SOH is input. The input unit 60 outputs the input instruction to the processor 56. When the control of the rechargeable battery 12 is started, the input unit 60 receives an input of the initial full charge capacity. For example, the control of the rechargeable battery 12 is started when the manager 16 is connected to the power distribution system 100 for the first time or when the rechargeable battery 12 is replaced. The former case is equivalent to replacement of the manager 16 in failure by another manager 16.

In these cases, the user initiates a mode of inputting the initial full charge capacity by using the button of the input unit 60. This causes the processor 56 to stand by for an input of the initial full charge capacity. The user then inputs the initial full charge capacity by using the button of the input unit 60. The processor 56 causes the storage 70 to store the received full charge capacity. The storage 70 stores the full charge capacity received by the input unit 60. In this way, the initial full charge capacity is initialized. The processor 56 uses the initialized initial full charge capacity to derive the SOH.

The features are implemented in hardware such as a CPU of a computer, a memory, or other LSI's, and in software such as a program loaded into a memory, etc. The figure depicts functional blocks implemented by the cooperation of these elements. Therefore, it will be obvious to those skilled in the art that the functional blocks may be implemented in a variety of manners by hardware only or by a combination of hardware and software.

A description will now be given of the operation of the power distribution system 100 having the structure described above. Fig. 10 is a flowchart showing the steps of inputting the full charge capacity performed by the manager 16. If the manager 16 or the rechargeable battery 12 is replaced (Y in S110), the input unit 60 receives an input of the initial full charge capacity (S112). If neither the manager 16 nor the rechargeable battery 12 is replaced (N in S110), step 112 is skipped.

According to this exemplary embodiment, an input of the initial full charge capacity is received to start controlling the rechargeable battery. Therefore, the initial full charge capacity can be flexibly set regardless of a change in the usage environment of the rechargeable battery. Because the initial full charge capacity is flexibly set, the SOH suitable for the rechargeable battery is acquired. Further, because the SOH suitable for the rechargeable battery is acquired, user convenience is improved.

(Sixth exemplary embodiment)

Like the fifth exemplary embodiment, the sixth exemplary embodiment relates to a manager adapted to initialize the initial full charge capacity when the usage environment of the rechargeable battery is changed. The manager according to the sixth exemplary embodiment does not directly receive the initial full charge capacity of the rechargeable battery but receives information related to the period of time elapsed since the rechargeable battery is started to be used and converts the period into the initial full charge capacity. The power distribution system 100 and the manager 16 according to the sixth exemplary embodiment are of the same type as those of Figs. 1A-1C and Fig. 9. The following description concerns the difference.

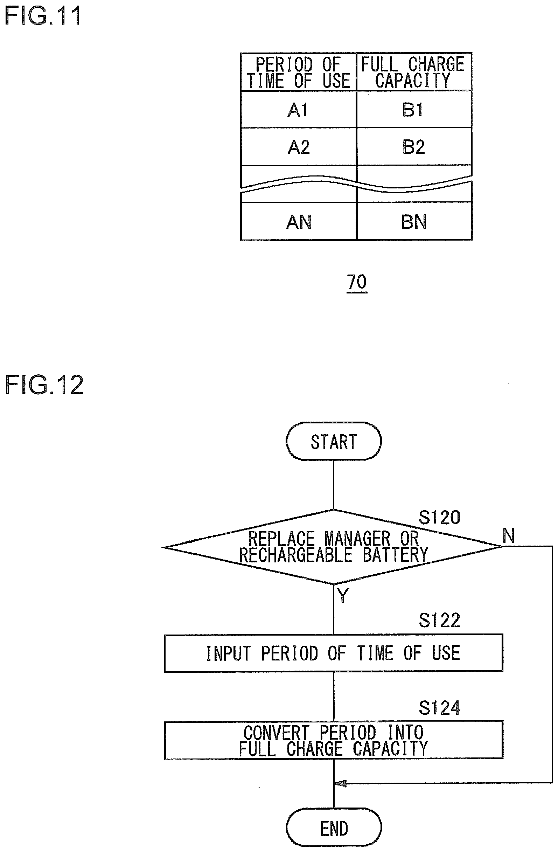

When the control of the rechargeable battery 12 is started, the input unit 60 of Fig. 9 receives a period of time of use elapsed since the rechargeable battery 12 is started to be used as an input for the full charge capacity. The storage 70 stores a table that maps the period of time of use to the full charge capacity. Fig. 11 shows the data structure of the table stored in the storage 70 according to the sixth exemplary embodiment of the present invention. As shown, the period of time of use and the full charge capacity are mapped to each other one to one. Reference is made back to Fig. 9. The processor 56 converts the period of time of use received by the input unit 60 into the initial full charge capacity by referring to the table stored in the storage 70. The processor 56 causes the storage 70 to store the result of conversion. The storage 70 stores the initial full charge capacity obtained by conversion by the processor 56.

A description will be given of the operation of the power distribution system 100 having the structure described above. Fig. 12 is a flowchart showing the steps of inputting the full charge capacity performed by the manager 16 according to the sixth exemplary embodiment. If the manager 16 or the rechargeable battery 12 is replaced (Y in S120), the input unit 60 receives an input of the period of time of use (S122). The processor 56 refers to the table stored in the storage 70 and converts the period of time of use into the initial full charge capacity (S124). If neither the manager 16 nor the rechargeable battery 12 is replaced (N in S120), steps 122 and 124 are skipped.

According to this exemplary embodiment, the input period of time of use is converted into the full charge capacity so that the initial full charge capacity can be set without inputting the full charge capacity. Since what is only required is to input the period of time of use, the input is more simplified than the case where the initial full charge capacity is input.

(Seventh exemplary embodiment)

Like the preceding embodiment, the seventh exemplary embodiment relates to a manager adapted to initialize the initial full charge capacity when the usage environment of the rechargeable battery is changed. The preceding embodiment requires the user to recognize a change in the usage environment of the rechargeable battery and to input the initial full charge capacity. Meanwhile, the manager according to the seventh exemplary embodiment automatically recognizes a change in the usage environment of the rechargeable battery and receives an input of the initial full charge capacity. The power distribution system 100 and the manager 16 according to the seventh exemplary embodiment are of the same type as those of Figs. 1A-1C and Fig. 9. The following description essentially concerns the difference.

An assumption in the seventh exemplary embodiment is that an identification number for identifying the rechargeable battery 12 is assigned to the rechargeable battery 12. The rechargeable battery 12 outputs the identification number as appropriate. The processor 56 of Fig. 9 receives the identification number of the rechargeable battery 12 from the rechargeable battery 12 subject to control. The rechargeable battery 12 may automatically output the identification number or output the identification number in accordance with a request from the processor 56. The storage 70 stores the acquired identification number. The processor 56 compares the identification number newly received with the identification number stored in the storage 70. If they match, the processor 56 suspends the process. Meanwhile, if they do not match, the processor 56 allows the user to perform a mode of inputting the initial full charge capacity. If the input mode is performed by the processor 56, i.e., if the identification number of the rechargeable battery 12 is changed, the input unit 60 receives an input of the initial full charge capacity to start controlling the rechargeable battery 12.

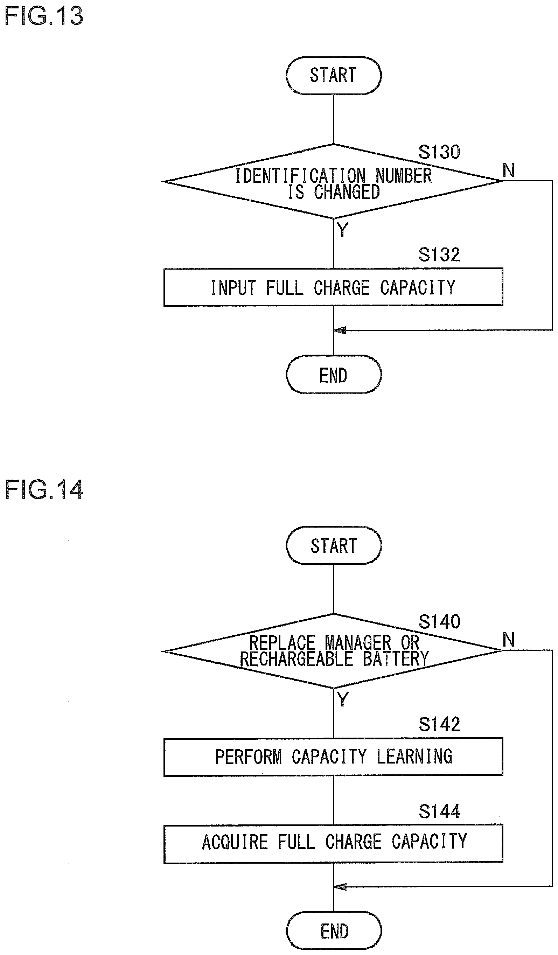

Fig. 13 is a flowchart showing the steps of inputting the full charge capacity performed by the manager 16 according to the seventh exemplary embodiment of the present invention. If the identification number of the rechargeable battery 12 is changed (Y in S130), the input unit 60 receives an input of the initial full charge capacity (S132). If the identification number of the rechargeable battery 12 is not changed (N in S130), step 132 is skipped.

According to this exemplary embodiment, the identification number of the rechargeable battery is monitored to start controlling the rechargeable battery so that the process is automated. Further, the full charge capacity is set easily since the process is automated.

(Eighth exemplary embodiment)

Like the preceding embodiment, the eighth exemplary embodiment relates to a manager adapted to initialize the initial full charge capacity when the usage environment of the rechargeable battery is changed. The preceding embodiment requires the user to input the initial full charge capacity or the period of time of use. Meanwhile, the manager according to the eighth exemplary embodiment acquires the initial full charge by performing capacity learning when the usage environment of the rechargeable battery 12 is changed. The power distribution system 100 and the manager 16 according to the eighth exemplary embodiment are of the same type as those of Figs. 1A-1C and Fig. 9. The following description essentially concerns the difference.

The processor 56 starts controlling the rechargeable battery 12 by forcing capacity learning of the rechargeable battery 12 to be performed. Capacity learning is a process whereby the rechargeable battery 12 is discharged and then charged afresh. A publicly known technology may be used for capacity learning. The processor 56 acquires the full charge capacity by performing capacity learning and causes the storage 70 to store the acquired capacity as the initial full charge capacity. The storage 70 stores the initial full charge capacity acquired by capacity learning.

Fig. 14 is a flowchart showing the steps of acquiring the full charge capacity performed by the manager 16 according to the eighth exemplary embodiment of the present invention. If the manager 16 or the rechargeable battery 12 is replaced (Y in S140), the processor 56 forces capacity learning to be performed (S142) so as to acquire the initial full charge capacity (S144). If neither the manager 16 nor the rechargeable battery 12 is replaced (N in S140), steps 142 and 144 are skipped.

According to this exemplary embodiment, the control of the rechargeable battery is started by forcing capacity learning of the rechargeable battery to be performed so that the initial full charge capacity is automatically acquired. Since the initial full charge capacity is automatically acquired, convenience is improved.

Described above is an explanation based on exemplary embodiments. The exemplary embodiments are intended to be illustrative only and it will be obvious to those skilled in the art that various modifications to constituting elements and processes could be developed and that such modifications are also within the scope of the present invention.

The exemplary embodiments require that the solar cell 10 be provided to generate power. However, any device other than the solar cell 10 capable of generating power based on a renewable energy source may be used. For example, a wind power generator may be used. According to this variation, the flexibility of the structure of the power distribution system 100 is improved.

According to the exemplary embodiments, notification is made by using the display 58. Alternatively, a speaker may be provided to notify the user by sound. According to this variation, the flexibility of designing the notification means is improved. The destination of outputting notification may be a server connected to a network.

According to the exemplary embodiments, the manager 16 is responsible for performing the processes. Alternatively, the converter 14 may be responsible for performing the processes. Still alternatively, the combination of the converter 14 and the manager 16 may be responsible for the processes. According to this variation, the flexibility of design is improved.

In the first through fourth exemplary embodiments of the present invention, the time of updating is used as indicating the reliability of the state of health. Alternatively, however, the depth of discharge of the state of health may be used. The depth of discharge is a numerical value indicating the state of discharge of a battery and is generally given by the percentage of the amount of discharge with respect to the rating capacity. Strictly, the current full charge capacity to determine the SOH should be calculated from the integrated current value obtained when the battery is charged and discharged between 0% and 100%. In practice, however, the current full charge capacity may be calculated by dividing the integrated current value obtained when the battery is charged and discharged between SOC=75% and SOC=50% by 25%. The difference 25% between 75% and 50% represents the depth of charge. It can further be said that the larger the range (depth of charge) in which the SOC is varied, i.e., in which the battery is charged and discharged, the higher the reliability of SOH calculated, and the smaller the range (depth of charge) in which the SOC is varied, i.e., in which the battery is charged and discharged, the lower the reliability of SOH calculated. According to this variation, various parameters can be used as a measure of reliability.

When an instruction to display the SOH is received via the input unit 60 according to the fifth through eighth exemplary embodiments before the latest SOH is derived subsequent to the initialization of the initial full charge capacity, the processor 56 may cause the display 58 to display a message prompting the user to perform capacity learning or forces capacity learning to be performed. In this case, the processor 56 may define the current full charge capacity to be identical to the initialized initial full charge capacity and display the SOH along with the time of updating such that SOH=100% and the time when the initial full charge capacity is initialized is the time of updating.

A summary of embodiments of the present invention will be given below. A controller according to an embodiment of the present invention includes a first acquisition unit that acquires a state of health of a rechargeable battery that should supply power to a load, a second acquisition unit that acquires a reliability of the state of health acquired by the first acquisition unit, and an output unit that outputs the state of health acquired by the first acquisition unit and the reliability acquired by the second acquisition unit.

According to the embodiment, the reliability is output along with the state of health so that the user can know how reliable the state of health is.

The reliability acquired by the second acquisition unit may be a time of updating the state of health acquired by the first acquisition unit. In this case, the time of updating is output along with the state of health so that the user can know when the state of health is acquired.

The reliability acquired by the second acquisition unit may be a depth of charge used to calculate the state of health.

The controller may further include a display that displays the state of health acquired by the first acquisition unit and the reliability acquired by the second acquisition unit.

The controller may further include a display that displays the state of health acquired by the first acquisition unit and the time of updating acquired by the second acquisition unit. If the time of updating acquired by the second acquisition unit indicates a date and time earlier than a predefined period of time in the past, the display may display a message prompting a user to perform capacity learning of the rechargeable battery. In this case, a message prompting the user to perform capacity learning of the rechargeable battery is displayed so that the state of health can be updated.

The controller may further include a processor that forces capacity learning to be performed if the time of updating acquired by the second acquisition unit indicates a date and time earlier than a predefined period of time in the past. In this case, capacity is learned so that the state of health can be updated.

The controller may further include a display that displays the state of health acquired by the first acquisition unit and the time of updating acquired by the second acquisition unit. The display may display that the time of updating is old if the time of updating acquired by the second acquisition unit indicates a date and time earlier than a predefined period of time in the past. In this case, a message indicating that the time of updating is old is displayed so that the user is alerted accordingly.

Another embodiment of the present invention relates to a control method. The method includes acquiring a state of health of a rechargeable battery that should supply power to a load, acquiring a reliability of the acquired state of health, and outputting the acquired state of health and the acquired reliability.

Still another embodiment of the present invention also relates to a controller. The controller includes a storage that stores a full charge capacity of a rechargeable battery that should supply power to a load and that is subject to control, a processor that performs a process by using the full charge capacity stored in the storage, and an input unit that receives an instruction to the processor. When the control of the rechargeable battery is started, the input unit receives an input of the full charge capacity, and the storage stores the full charge capacity received by the input unit.

According to the embodiment, an input of the initial full charge capacity is received to start controlling the rechargeable battery. Therefore, the initial full charge capacity can be flexibly set regardless of a change in the usage environment of the rechargeable battery.

The input unit may receive a period of time elapsed since the rechargeable battery is started to be used as an input for the full charge capacity, when the control of the rechargeable battery is started. The processor may convert the period of time of use received by the input unit into the initial full charge capacity by referring to a table that maps the period of time of use to the full charge capacity. The storage may store the initial full charge capacity converted by the processor. In this case, the input period of time of use is converted into the full charge capacity so that the input is simplified.

The processor may receive from the rechargeable battery subject to control an identification number of the rechargeable battery, and the input unit may learn that the control of the rechargeable battery is started when the identification number of the rechargeable battery is changed. In this case, the control of the rechargeable battery is started by monitoring the identification number of the rechargeable battery so that the full charge capacity can be easily set.

Still another embodiment of the present invention also relates to a controller. The controller includes a storage that stores a full charge capacity of a rechargeable battery that should supply power to a load and that is subject to control, and a processor that performs a process by using the full charge capacity stored in the storage. To start controlling the rechargeable battery, the processor causes capacity learning of the rechargeable battery to be performed and the storage stores the full charge capacity acquired by capacity learning.

According to this embodiment, capacity learning of the rechargeable battery is performed to start controlling the rechargeable battery so that convenience is improved.

Still another embodiment of the present invention also relates to a control method. The method includes acquiring, from a memory storing a full charge capacity of a battery that should supply power to a load and that is subject to control, the full charge capacity, performing a process by using the acquired full charge capacity, and receiving an instruction related to the performing of a process. The inputting receives an input of the full charge capacity when the control of the rechargeable battery is started, and the performing of a process stores the received full charge capacity in a memory.

Still another embodiment of the present invention also relates to a control method. The method includes acquiring, from a memory storing a full charge capacity of a battery that should supply power to a load and that is subject to control, the full charge capacity, and performing a process by using the acquired full charge capacity. The inputting causes capacity learning of the rechargeable battery to be performed when the control of the rechargeable battery is started, and stores the full charge capacity acquired by capacity learning in a memory.

[DESCRIPTION OF THE REFERENCE NUMERALS]

10 solar cell, 12 rechargeable battery, 14 converter, 16 manager, 18 first SW, 20 second SW, 22 commercial power supply, 24 special load, 26 general load, 56 processor, 58 display, 60 input unit, 68 first acquisition unit, 70 storage, 72 second acquisition unit, 100 power distribution system

[INDUSTRIAL APPLICABILITY]

According to the invention, the reliability of the state of health can be made known.

**Claims**

1.  A controller (16) comprising:

    a first acquisition unit (68) configured to acquire a state of health of a rechargeable battery that should supply power to a load by dividing a current full charge capacity by an initial full charge capacity if a certain constant quantity of power is charged in or discharged from the rechargeable battery; and
    a second acquisition unit (72) configured to acquire a time of updating the state of health acquired by the first acquisition unit (68);

    the controller being **characterised**
    **in that** if further comprises:

    a display (58) configured to display the state of health acquired by the first acquisition unit (68) and the time of updating the state of health acquired by the second acquisition unit (72).

2.  The controller (16) according to claim 1,
    wherein
    if the time of updating the state of health acquired by the second acquisition unit (72) indicates a date and time earlier than a predefined period of time in the past, the display (58) displays a message prompting a user to perform capacity learning of the rechargeable battery.

3.  The controller (16) according to claim 1, further comprising:

    a processor (56) configured to force capacity learning of the rechargeable battery to be performed if the time of updating the state of health acquired by the second acquisition unit (72) indicates a date and time earlier than a predefined period of time in the past.

4.  The controller (16) according to claim 1,
    wherein
    the display (58) displays that the time of updating is old if the time of updating acquired by the second acquisition unit (72) indicates a date and time earlier than a predefined period of time in the past.

5.  A control method comprising:

    acquiring a state of health of a rechargeable battery that should supply power to a load by dividing a current full charge capacity by an initial full charge capacity if a certain constant quantity of power is charged in or discharged from the rechargeable battery;
    acquiring a time of updating the acquired state of health; and
    displaying the acquired state of health and the acquired time of updating the acquired state of health.

**Patentansprüche**

1.  Steuereinrichtung (16), aufweisend:

    eine erste Akquisitionseinheit (68), die dazu eingerichtet ist, einen Allgemeinzustand einer wiederaufladbaren Batterie, die einer Last Strom zuführen sollte, durch Dividieren einer aktuellen vollen Ladungskapazität durch eine ursprüngliche volle Ladungskapazität zu erhalten, falls die wiederaufladbare Batterie mit einer gewissen konstanten Strommenge geladen oder entladen wird; und

eine zweite Akquisitionseinheit (72), die dazu eingerichtet ist, einen Zeitpunkt einer Aktualisierung des Allgemeinzustands zu erhalten, der durch die erste Akquisitionseinheit (68) erhalten wurde;

wobei die Steuereinrichtung **dadurch gekennzeichnet ist, dass** sie ferner enthält:

eine Anzeigevorrichtung (58), die dazu eingerichtet ist, den Allgemeinzustand, der durch die erste Akquisitionseinheit (68) erhalten wurde, und den Zeitpunkt einer Aktualisierung des Allgemeinzustands anzuzeigen, der durch die zweite Akquisitionseinheit (72) erhalten wurde.

2. Steuereinrichtung (16) nach Anspruch 1, wobei,
falls der Zeitpunkt der Aktualisierung des Allgemeinzustands, der durch die zweite Akquisitionseinheit (72) erhalten wurde, ein Datum und eine Uhrzeit angibt, die vor einer vordefinierten Zeitspanne in der Vergangenheit liegen, die Anzeigeeinrichtung (58) eine Meldung anzeigt, die einen Benutzer auffordert, eine Kapazitätserforschung der wiederaufladbaren Batterie durchzuführen.

3. Steuereinrichtung (16) nach Anspruch 1, ferner aufweisend:

einen Prozessor (56), der dazu eingerichtet ist, zu veranlassen, dass die Kapazitätserforschung der wiederaufladbaren Batterie durchgeführt wird, falls der Zeitpunkt der Aktualisierung des Allgemeinzustands, der durch die zweite Akquisitionseinheit (72) erhalten wurde, ein Datum und eine Uhrzeit angibt, die vor einer vordefinierten Zeitspanne in der Vergangenheit liegen.

4. Steuereinrichtung (16) nach Anspruch 1, wobei
das Display (58) anzeigt, dass die Zeit einer Aktualisierung veraltet ist, falls der Zeitpunkt der Aktualisierung, der durch die zweite Akquisitionseinheit (72) erhalten wurde, ein Datum und eine Uhrzeit angibt, die vor einer vordefinierten Zeitspanne in der Vergangenheit liegen.

5. Steuerungsverfahren, umfassend:

Erhalten eines Allgemeinzustands einer wiederaufladbaren Batterie, die einer Last Strom zuführen sollte, durch Dividieren einer aktuellen vollen Ladungskapazität durch eine ursprüngliche volle Ladungskapazität, falls die wiederaufladbare Batterie mit einer gewissen konstanten Strommenge geladen oder entladen wird;
Erhalten eines Zeitpunkts einer Aktualisierung des erhaltenen Allgemeinzustands; und
Anzeigen des erhaltenen Allgemeinzustands und des erhaltenen Zeitpunkts einer Aktualisierung des erhaltenen Allgemeinzustands.

## Revendications

1. Contrôleur (16) comprenant :

une première unité d'acquisition (68) configurée de manière à acquérir un état de santé d'une batterie rechargeable qui doit alimenter une charge en divisant une capacité de charge totale en cours par une capacité de charge totale initiale si une certaine quantité de puissance constante est chargée dans ou déchargée à partir de la batterie rechargeable ; et
une seconde unité d'acquisition (72) configurée de manière à acquérir un instant de mise à jour de l'état de santé acquis par la première unité d'acquisition (68) ;

le contrôleur étant **caractérisé en ce qu'**il comprend en outre :

un affichage (58) configuré de manière à afficher l'état de santé acquis par la première unité d'acquisition (68) et l'instant de mise à jour de l'état de santé acquis par la seconde unité d'acquisition (72).

2. Contrôleur (16) selon la revendication 1,
dans lequel
si l'instant de mise à jour de l'état de santé acquis par la seconde unité d'acquisition (72) indique une date et une heure antérieures à une période de temps prédéfinie dans le passé, l'affichage (58) affiche un message demandant à un utilisateur de mettre en oeuvre un apprentissage de capacité de la batterie rechargeable.

3. Contrôleur (16) selon la revendication 1, comprenant en outre :

   un processeur (56) configuré de manère à forcer un apprentissage de capacité de la batterie rechargeable devant être mis en oeuvre si l'instant de mise à jour de l'état de santé acquis par la seconde unité d'acquisition (72) indique une date et une heure antérieures à une période de temps prédéfinie dans le passé.

4. Contrôleur (16) selon la revendication 1,
   dans lequel
   l'affichage (58) indique que l'instant de mise à jour est ancien si l'instant de mise à jour acquis par la seconde unité d'acquisition (72) indique une date et une heure antérieures à une période de temps prédéfinie dans le passé.

5. Procédé de commande comprenant les étapes ci-dessous consistant à :

   acquérir un état de santé d'une batterie rechargeable qui doit alimenter une charge en divisant une capacité de charge totale en cours par une capacité de charge totale initiale si une certaine quantité de puissance constante est chargée dans ou déchargée à partir de la batterie rechargeable ;
   acquérir un instant de mise à jour de l'état de santé acquis ; et
   afficher l'état de santé acquis et l'instant de mise à jour de l'état de santé acquis.

FIG.1A

FIG.1B

FIG.1C

FIG.2

16

FIG.3

SOH  70%

2010 . 4 . 1

58

FIG.4

SOH  70%
2008 . 4 . 1
PERFORM CAPACITY
LEARNING

58

FIG.5

```
                    ┌─────────┐
                    │  START  │
                    └────┬────┘
                         │
                         │                    S10
                    ╱────┴────╲
                  ╱  TIME OF    ╲    N
                 ⟨   UPDATING    ⟩──────┐
                  ╲   IS OLD    ╱       │
                    ╲────┬────╱         │
                         │ Y            │
                         │        S12   │
          ┌──────────────┴──────────────┐
          │  DISPLAY MESSAGE PROMPTING   │
          │  USER TO PERFORM CAPACITY    │
          │         LEARNING             │
          └──────────────┬──────────────┘
                         │◄─────────────┘
                    ┌────┴────┐
                    │   END   │
                    └─────────┘
```

FIG.6

```
                    ┌─────────┐
                    │  START  │
                    └────┬────┘
                         │
                         │                    S20
                    ╱────┴────╲
                  ╱  TIME OF    ╲    N
                 ⟨   UPDATING    ⟩──────┐
                  ╲   IS OLD    ╱       │
                    ╲────┬────╱         │
                         │ Y            │
                         │        S22   │
          ┌──────────────┴──────────────┐
          │   FORCE CAPACITY LEARNING    │
          │       TO BE PERFORMED        │
          └──────────────┬──────────────┘
                         │◄─────────────┘
                    ┌────┴────┐
                    │   END   │
                    └─────────┘
```

## FIG.7

```
SOH   70%
2008.4.1
TIME OF UPDATING
SOH IS OLD
```

58

## FIG.8

FIG.9

16

FIG.10

FIG.11

| PERIOD OF TIME OF USE | FULL CHARGE CAPACITY |
|:---:|:---:|
| A1 | B1 |
| A2 | B2 |
| AN | BN |

70

FIG.12

```
        ┌─────────┐
        │  START  │
        └─────────┘
             │
             │                    S120
          ╱  REPLACE MANAGER OR  ╲      N
        ╱   RECHARGEABLE BATTERY   ╲─────────┐
          ╲                      ╱           │
             ╲                ╱              │
                │ Y                          │
                │            S122            │
     ┌──────────────────────────────┐       │
     │   INPUT PERIOD OF TIME OF USE │       │
     └──────────────────────────────┘       │
                │            S124            │
     ┌──────────────────────────────┐       │
     │     CONVERT PERIOD INTO       │       │
     │    FULL CHARGE CAPACITY       │       │
     └──────────────────────────────┘       │
                │◄──────────────────────────┘
          ┌─────────┐
          │   END   │
          └─────────┘
```

FIG.13

```
                    ┌─────────┐
                    │  START  │
                    └────┬────┘
                         │
                         │                    S130
                  ╱──────┴──────╲
          ╱──────────────────────────────╲      N
         ╱   IDENTIFICATION NUMBER         ╲─────────┐
         ╲        IS CHANGED               ╱         │
          ╲──────────────────────────────╱          │
                  ╲──────┬──────╱                    │
                         │ Y                         │
                         │              S132         │
         ┌───────────────┴────────────────┐          │
         │    INPUT FULL CHARGE CAPACITY   │          │
         └───────────────┬────────────────┘          │
                         │◄──────────────────────────┘
                    ┌────┴────┐
                    │   END   │
                    └─────────┘
```

FIG.14

```
                    ┌─────────┐
                    │  START  │
                    └────┬────┘
                         │
                         │                    S140
                  ╱──────┴──────╲
          ╱──────────────────────────────╲      N
         ╱    REPLACE MANAGER OR           ╲─────────┐
         ╲   RECHARGEABLE BATTERY          ╱         │
          ╲──────────────────────────────╱          │
                  ╲──────┬──────╱                    │
                         │ Y                         │
                         │              S142         │
         ┌───────────────┴────────────────┐          │
         │    PERFORM CAPACITY LEARNING    │          │
         └───────────────┬────────────────┘          │
                         │              S144         │
         ┌───────────────┴────────────────┐          │
         │   ACQUIRE FULL CHARGE CAPACITY  │          │
         └───────────────┬────────────────┘          │
                         │◄──────────────────────────┘
                    ┌────┴────┐
                    │   END   │
                    └─────────┘
```

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2011075461 A
- US 2010244846 A1
- US 2005001627 A1
- US 2010121587 A1
- JP 2008256673 A
- JP 2010032480 A
- JP 2012073175 A